# FASCICULE DE BREVET EUROPEEN

(11) **EP 2 071 722 B1**
(45) Date de publication et mention de la délivrance du brevet: **22.09.2010**
(21) Numéro de dépôt: 08305753.9
(22) Date de dépôt: 30.10.2008
(51) Int. Cl.: H03K 5/04, G01T 1/17

(54) **Dispositif pour réaliser le traitement et la numérisation d'un spectre en énergie d'un rayonnement électromagnétique**
Vorrichtung zur Umsetzung der Datenverarbeitung und Digitalisierung eines Energiespektrums aus elektromagnetischer Strahlung
Device for processing and digitising an energy spectrum of an electromagnetic radiation

(30) Priorité: 13.12.2007 FR 0759816
(43) Date de publication de la demande: 17.06.2009
(73) Titulaire: Commissariat à l'Énergie Atomique et aux Énergies Alternatives, 75015 Paris (FR)
(72) Inventeur: Ouvrier-Buffet, Patrice, 74410 Saint-Jorioz (FR); De la Rosa, Ken-Ji, 05110 Lardier et Valenca (FR)
(74) Mandataire: Vuillermoz, Bruno

(56) Documents cités:
- EP-A- 1 762 854
- FR-A- 2 847 676
- FR-A- 2 864 628

## Description

### DOMAINE DE L'INVENTION

La présente invention a trait domaine de la détection de rayonnement ionisant au moyen d'un détecteur semi-conducteur fonctionnant à température ambiante, et notamment le domaine du traitement de charges électriques produites par la ionisation d'un élément semi-conducteur suite à son bombardement par des photons.

### ETAT ANTERIEUR DE LA TECHNIQUE

Les détecteurs à base de semi-conducteur, comme par exemple les détecteurs à matrice de photodiodes ou de phototransistors, permettent de réaliser la conversion directe du rayonnement incident en signal électrique, et trouvent application dans de nombreux domaines comme l'imagerie médicale, le contrôle de bagages ou les sondes nucléaires par exemple.

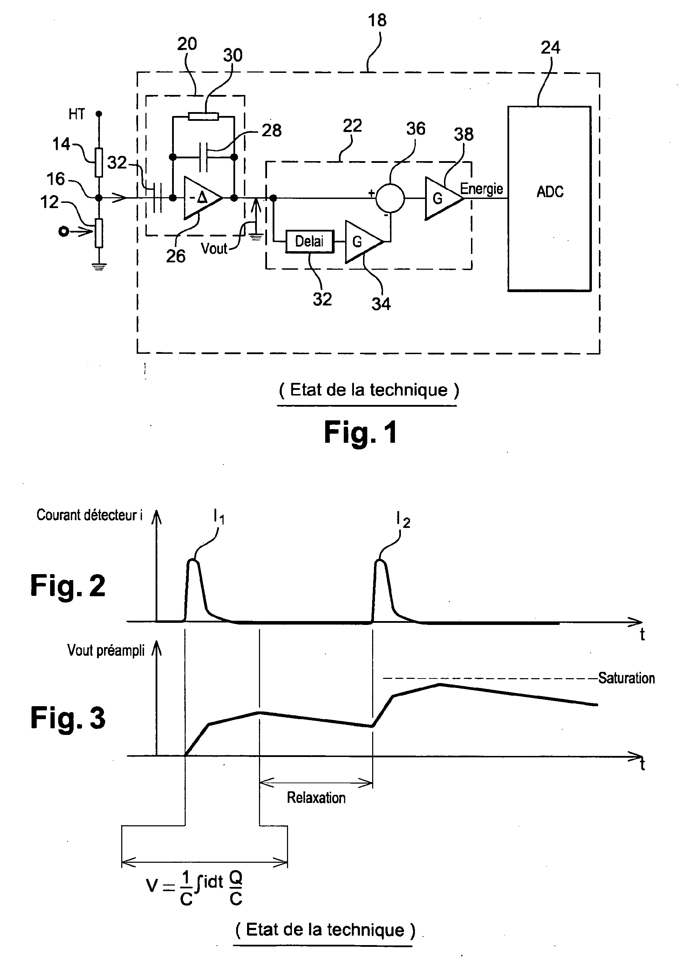

Un spectromètre classique, c'est-à-dire un détecteur couplé à une chaîne de traitement et de numérisation qui détermine le spectre en énergie du rayonnement reçu par le détecteur, est illustré à la figure 1 sous la référence générale **10.** Le spectromètre **10,** conçu pour les applications où un fort taux de comptage des photons incidents sur le détecteur est nécessaire, mesure l'énergie des photons à l'aide d'une ligne à retard.

Ce spectromètre **10** comprend un détecteur à semi-conducteur **12,** comme par exemple du CdZnTe, du CdTe :Cl, ou du CdTe :In, polarisé sous une tension continue « HT » au travers d'une résistance **14.**

Le détecteur **12** est soumis à un rayonnement de photons, par exemple des photons gamma ou des photons X, qui ionisent le matériau semi-conducteur. Les charges ainsi produites migrent alors vers des électrodes (non représentées) du détecteur **12** en raison de l'existence de la tension de polarisation HT.

Le courant de charge « i » ainsi généré est récupéré sur une électrode de collecte **16** par une chaîne de traitement et de numérisation **18,** qui compte les photons incidents en fonction de leur énergie afin d'obtenir le spectre en énergie du rayonnement.

La chaîne **16** comprend un préamplificateur de charges faible bruit **20** monté en intégrateur, un circuit **22** de mesure d'énergie par ligne à retard, ainsi qu'un convertisseur analogique/numérique **24.**

Le préamplificateur **20** comprend un amplificateur **26** à grand gain, monté en contre-réaction avec un montage parallèle d'une capacité **28,** de valeur C₁, et d'une résistance **30,** de valeur R₁, ainsi qu'une capacité **32** connectée entre l'électrode de collecte **16** et l'entrée de l'amplificateur **26.**

La figure 2 illustre deux impulsions I₁ et I₂ du courant i résultant de l'interaction de deux photons avec le détecteur **12,** et la figure 3 illustre la tension Vₒᵤₜ correspondante en sortie du préamplificateur **20.**

Le circuit **22** de mesure d'énergie comprend quant à lui une ligne à retard **32,** connectée en sortie du préamplificateur **20** et appliquant à celle-ci un retard Δ*t* prédéterminé, et un premier gain **34,** connecté à la sortie de la ligne **32.**

Le circuit **22** de mesure d'énergie comporte également un soustracteur **36,** connecté au préamplificateur **20** et au premier gain **34** et réalisant la différence entre les sorties de ceux-ci. Enfin, un second gain **38** est prévu en sortie du soustracteur.

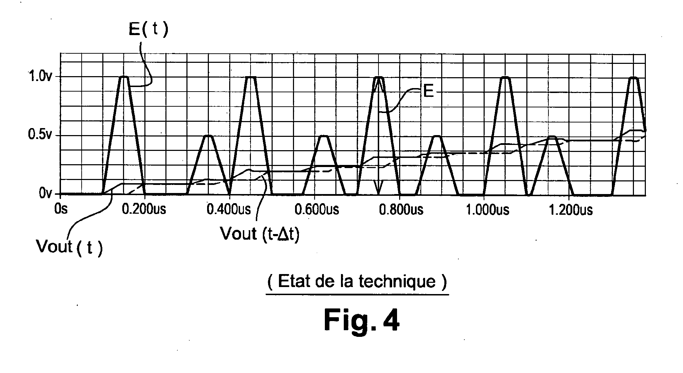

La figure 4 illustre en fonction du temps « t » une tension Vₒᵤₜ(t) en sortie du préamplificateur **20,** la tension retardée correspondante en sortie du premier gain **34** Vₒᵤₜ(t-Δ*t*), et la tension E(t) correspondante en sortie du circuit **22** de mesure d'énergie.

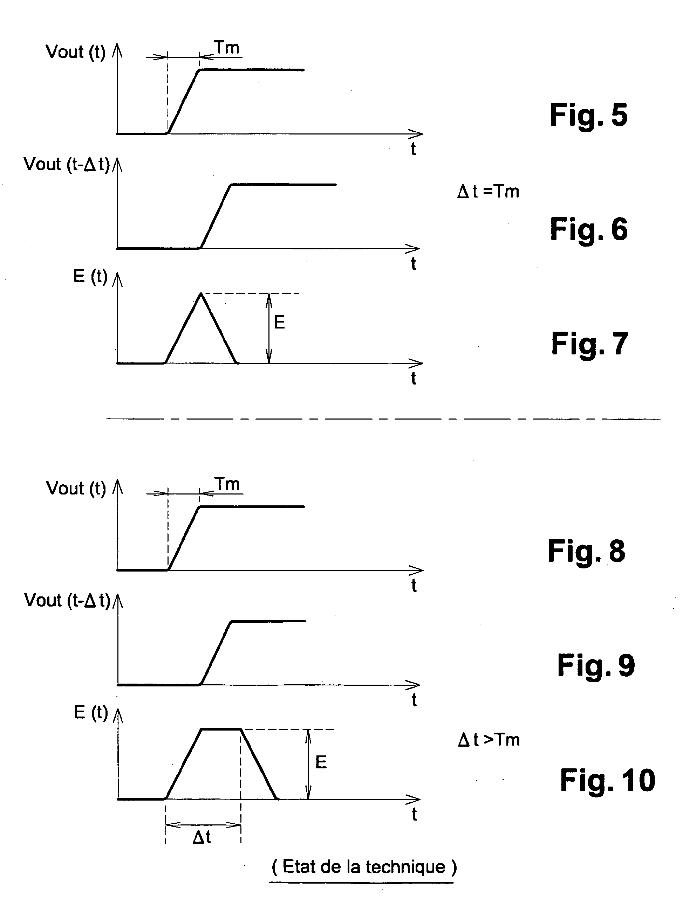

Le circuit **22** de mesure d'énergie génère donc des impulsions de tension correspondant aux impulsions de charge générées par le photon incident sur le détecteur. On montre que l'amplitude d'une impulsion en sortie du circuit **22** est proportionnelle à l'énergie du photon correspondant si et seulement si le retard Δ*t* est supérieur au temps de montée *Tₘ* de la tension Vₒᵤₜ en sortie du préamplificateur **20.** Les figures 5 à 10 illustrent, en fonction du temps, la forme d'une impulsion E(t) en sortie du circuit **22** pour Δ*t* = *Tₘ* (figures 5 à 7) et pour Δ*t* > *Tₘ* (figures 8 à 10).

La tension en sortie du circuit de mesure **22** est alors convertie en tension numérique par le convertisseur **24,** c'est-à-dire quantifiée et échantillonnée dans le temps à une fréquence d'échantillonnage prédéterminée fₑ.

La tension numérique est ensuite délivrée à un module de traitement numérique (non représenté) qui détecte les pics de la tension numérique pour déterminer l'énergie des photons et ainsi construire un spectre d'énergie du rayonnement incident sur le détecteur.

Le système venant d'être décrit permet un fort taux de comptage (de l'ordre de quelques Mégaphotons par seconde).

Toutefois, l'échantillonnage et la génération de charges dans la détection sont des évènements asynchrones. De fait, certains instants d'échantillonnage peuvent être mal appropriés car ne correspondant pas aux maxima de la tension en sortie du circuit de mesure. Ce problème est d'autant plus sensible que les pics de cette tension présentent des pentes très raides. Pour atténuer un tel inconvénient, il est possible d'augmenter de façon significative la fréquence d'échantillonnage du convertisseur mais au prix de matériel très coûteux et consommateur d'énergie.

### EXPOSE DE L'INVENTION

Le but de la présente invention est de résoudre le problème susmentionné en proposant une chaîne de traitement et de numérisation qui synchronise l'échantillonnage avec la production d'impulsions de courant dans le détecteur.

A cet effet, l'invention a pour objet un dispositif destiné à réaliser le traitement et la numérisation d'un spectre en énergie d'un rayonnement, comprenant :
■ un circuit de pré-amplification de charges du type intégrateur, apte à être connecté à un détecteur à semi-conducteur ;
■ un circuit de mesure d'énergie par ligne à retard connecté en sortie du circuit de pré-amplification ; et
■ un échantillonneur connecté en sortie du circuit de mesure d'énergie.

Selon l'invention, ce dispositif comporte un circuit de synchronisation comprenant :
■ un circuit de mesure d'impulsions de courant réalisant la différence entre la sortie et une dérivée de la sortie du circuit de pré-amplification ; et
■ un circuit de discrimination réalisant un signal binaire en fonction de la sortie du circuit de mesure d'impulsions, ledit signal logique commandant les instants d'échantillonnage de l'échantillonneur.

En d'autres termes, le circuit de synchronisation génère des impulsions synchrones avec les impulsions de courant au niveau de l'électrode de collecte du détecteur. On dispose donc d'un signal d'échantillonnage pour la sortie du circuit de mesure d'énergie de sorte qu'il n'est pas nécessaire d'utiliser un convertisseur à très haute fréquence d'échantillonnage.

Selon des modes de réalisation particuliers de l'invention, le système comporte une ou plusieurs des caractéristiques suivantes.

Le circuit de synchronisation comporte en outre un circuit de filtrage apte à éliminer les impulsions du signal logique, présentant une durée supérieure à une durée prédéterminée de seuil. Notamment, la durée prédéterminée de seuil est inférieure ou égale au temps de montée du circuit de pré-amplification de charge.

En d'autres termes, le comptage et la mesure des charges générées par des photons incidents sur le détecteur de manière sensiblement simultanée sont écartés. On sait en effet que de tels empilements de charges faussent le spectre en énergie du rayonnement lorsqu'ils sont pris en compte.

La constante de temps d'intégration du circuit de pré-amplification est sensiblement égale à la constante de temps de dérivation du circuit de mesure d'impulsions.

Ainsi, les impulsions générées en sortie du circuit de mesure d'impulsions sont sensiblement proportionnelles aux impulsions de courant en sortie du détecteur, ce qui augmente la précision de la synchronisation.

Le circuit de mesure d'impulsions comporte :
■ un étage dérivateur comprenant un amplificateur grand gain, une capacité connectée en entrée de l'amplificateur grand gain et une résistance connectée entre l'entrée et la sortie de l'amplificateur grand gain ; et
■ un étage soustracteur connecté aux sorties du circuit de pré-amplification et de l'étage dérivateur.

### BREVE DESCRIPTION DES FIGURES

L'invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :
- la figure 1 est une vue schématique d'un spectromètre de l'état antérieur de la technique, discuté en relation avec le préambule ;
- les figures 2 à 10 sont des courbes de signaux résultant de la mise en oeuvre du spectromètre de la figure 1 ;
- la figure 11 est un spectromètre conforme à l'invention ;
- les figures 12, 13 et 14 sont des courbes de signaux résultant de la mise en oeuvre du spectromètre de la figure 11.

### DESCRIPTION DETAILLEE DE L'INVENTION

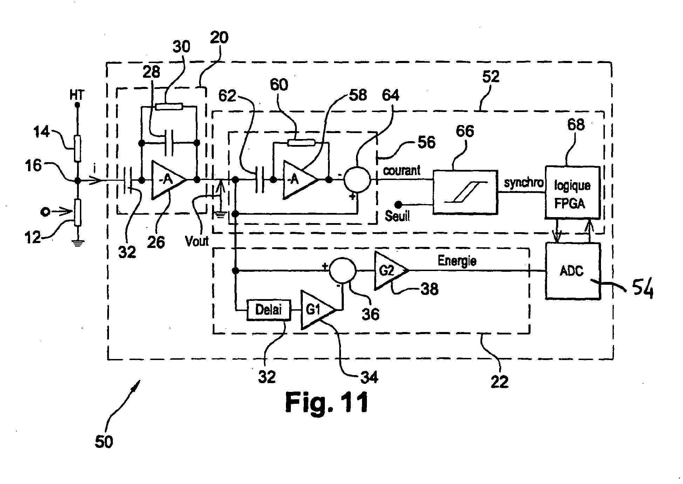

Sur la figure 11, le détecteur **12** est associé à une chaîne de traitement et de numérisation **50** selon l'invention.

Outre le préamplificateur **20** et le circuit **22** de mesure d'énergie, la chaîne 50 comporte un circuit **52** de synchronisation et un convertisseur analogique/numérique **54** piloté par le circuit **52** de synchronisation.

Le circuit de synchronisation **52** comporte un circuit **56** de mesure d'impulsions comportant un amplificateur grand gain **58** monté en contre-réaction avec une résistance **60,** de valeur R₂ et une capacité **62,** de valeur C₂, connectée entre l'entrée de l'amplificateur **58** et la sortie du préamplificateur **20.** Le circuit **56** de mesure d'impulsion comprend également un soustracteur **64,** connecté aux sorties du préamplificateur **20** et de l'amplificateur **58** et réalisant la différence de celles-ci.

Le circuit **56** de mesure d'impulsions réalise donc la différence entre la sortie du préamplificateur **20** et une dérivée de celle-ci déterminée par les éléments **58, 60** et **62.**

De préférence, les constantes de temps de la dérivation réalisée par les éléments **58, 60** et **62,** et de l'intégration, réalisée par le préamplificateur **20,** sont sensiblement égales, c'est-à-dire vérifient la relation R₂C₂ = R₁C₁. De cette manière, la sortie du soustracteur **64** est sensiblement proportionnelle au courant i à l'électrode de collecte **16.**

Pour plus de détails sur le fonctionnement et les avantages procurés par un tel circuit de mesure d'impulsions, on pourra se reporter au document EP 1 762 854.

Le circuit de synchronisation comporte par ailleurs un circuit de discrimination **66** à seuil connecté à la sortie du soustracteur **64.** Le circuit **66** sature à une première valeur la sortie du circuit **56** de mesure d'impulsions lorsque celle-ci est supérieure à un seuil prédéterminé, et sinon sature la sortie du circuit **66** à une seconde valeur, par exemple 0. Il est ainsi obtenu en sortie du circuit de discrimination **66** un signal binaire formée d'impulsions qui sont synchrones avec les impulsions du courant i à l'électrode de collecte **16.**

De préférence, le circuit de synchronisation **62** comporte un circuit logique **68** mettant en oeuvre un filtre qui élimine les impulsions de durée supérieure à une valeur prédéterminée T_{mc}. La valeur Tₘₑ est choisie sensiblement égale au temps de montée du préamplificateur **22** qui correspond à la largeur de l'impulsion de courant produite par l'interaction d'un seul photon dans le détecteur **12.** Cette largeur dépend des caractéristiques du détecteur **12** ainsi que de la tension de polarisation HT de ce dernier. De cette manière, les impulsions correspondant en fait à un empilement de charges dans le détecteur produit par le bombardement quasi-simultané de celui-ci par plusieurs photons, sont éliminées sans qu'il soit besoin de faire appel à des algorithmes complexes.

Le convertisseur analogique/numérique **54** numérise quant à lui la sortie du circuit de mesure d'impulsions **22** en utilisant les impulsions du circuit de synchronisation **52.** Le déclenchement de la numérisation est initialisé sur le front montant (ou descendant) du circuit de synchronisation **52** et, en introduisant un retard réglable, il est possible de synchroniser de manière précise l'instant de numérisation avec les pics de tension en sortie du circuit de mesure **22.**

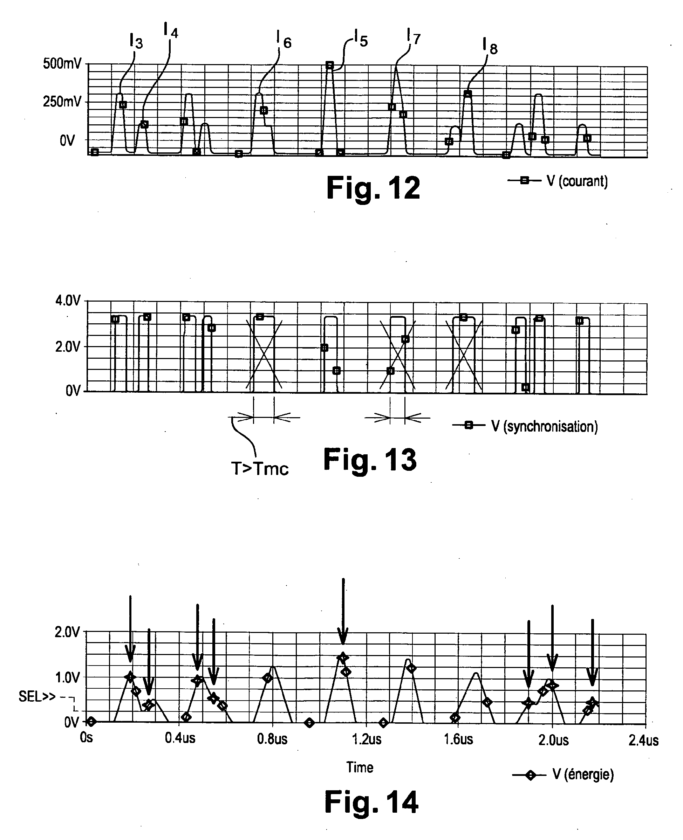

La figure 12 est un exemple de courant i collecté en sortie du détecteur **14.** On y observe des impulsions générées par un seul photon, comme par exemple les impulsions I₃, I₄, I₅, et des impulsions générées par deux photons, comme par exemple les impulsions I₆, I₇ et I₈.

Sur la figure 13, il est tracé la tension binaire correspondante en sortie du circuit de synchronisation **52** sans élimination des impulsions I₆, I₇ et I₈ générées par plusieurs photons et avec éliminations de ces impulsions (impulsions barrées d'une croix).

La figure 14 est quant à elle un tracé de la tension en sortie du circuit de mesure d'énergie **22** sur lequel les instants de numérisation par le convertisseur **54** sont repérés par des étoiles.

Grâce à l'invention, il est ainsi obtenu les avantages suivants :
■ une synchronisation de la numérisation sur la génération des impulsions de courant dans le détecteur ;
■ un fort taux de comptage, supérieur à 10 Mégaphotons par seconde, est rendu possible. En effet, la mesure de l'énergie des impulsions est réalisée avec un temps mort proche du temps de transit des charges dans le détecteur ; et
■ une élimination simple et efficace des impulsions produites par un empilement de charge.

## Revendications

1. Dispositif pour réaliser le traitement et la numérisation d'un spectre en énergie d'un rayonnement, comportant :
■ un circuit (20) de pré-amplification de charges du type intégrateur, apte à être connecté à un détecteur à semi-conducteur ;
■ un circuit (22) de mesure d'énergie par ligne à retard, connecté en sortie du circuit de pré-amplification ; et
■ un échantillonneur (54) connecté en sortie du circuit de mesure d'énergie, ***caractérisé* en ce qu'**il comporte un circuit de synchronisation (52) comprenant :
■ un circuit (56) de mesure d'impulsions de courant, connecté en sortie du circuit de pré-amplification (20) et réalisant la différence entre la sortie et une dérivée de la sortie du circuit de pré-amplification ; et
■ un circuit de discrimination (66) formant un signal binaire en fonction de la sortie du circuit (22) de mesure d'impulsions, ledit signal logique commandant les instants d'échantillonnage de l'échantillonneur (54).

2. Dispositif selon la revendication 1, ***caractérisé* en ce que** le circuit de synchronisation (52) comporte en outre un circuit de filtrage (68) apte à éliminer les impulsions du signal logique, présentant une durée supérieure à une durée prédéterminée de seuil.

3. Dispositif selon la revendication 2, ***caractérisé* en ce que** la durée prédéterminée de seuil est inférieure ou égale au temps de montée du circuit de pré-amplification de charge (20).

4. Dispositif selon l'une des revendications 1 à 3, ***caractérisé* en ce que** la constante de temps d'intégration du circuit de pré-amplification (20) est sensiblement égale à la constante de temps de dérivation du circuit (56) de mesure d'impulsions.

5. Dispositif selon l'une quelconque des revendications précédentes, ***caractérisé* en ce que** le circuit (56) de mesure d'impulsions comporte :
■ un étage dérivateur (58, 60, 62) comprenant un amplificateur grand gain (58), une capacité (62) connectée en entrée de l'amplificateur grand gain (58), et une résistance (60) connectée entre l'entrée et la sortie de l'amplificateur grand gain ; et
■ un étage (64) soustracteur connecté aux sorties du circuit de pré-amplification et de l'étage dérivateur.

## Claims

1. A device for processing and digitizing an energy spectrum of a radiation, comprising:
■ a charge preamplification circuit (20) of the integrating circuit type, suitable for being connected to a semiconductor detector;
■ a lag line energy measurement circuit (22) connected to the output of the preamplification circuit; and
■ a sampler (54) connected to the output of the energy measurement circuit,
**characterized in that** it comprises a synchronization circuit (52) including:
■ a current pulse measurement circuit (56) connected to the output of the preamplification circuit (20) and calculating the difference between the output and a differential of the output of the preamplification circuit; and
■ a discrimination circuit (66) forming a binary signal according to the output of the pulse measurement circuit (22) said logic signal controlling the sampling times of the sampler (54).

2. The device as claimed in claim 1, ***characterized* in that** the synchronization circuits (52) further comprises a smoothing circuit (68) for eliminating the pulses of the logic signal, having a duration longer than a predefined threshold duration.

3. The device as claimed in claim 2, ***characterized* in that** the predefined threshold duration is shorter than or equal to the rise time of the charge preamplification circuit (20).

4. The device as claimed in one of claims 1 to 3, ***characterized* in that** the integration time constant of the preamplification circuit (20) is substantially equal to the differentiation time constant of the pulse measurement circuit (56).

5. The device as claimed in any one of the preceding claims, ***characterized* in that** the pulse measurement circuit (56) comprises:
■ a differentiator stage (58, 60, 62) comprising a high gain amplifier (58), a capacitance (62) connected to the input of the high gain preamplifier (58), and a resistance (60) connected between the input and the output of the high gain preamplifier; and
■ the subtractor stage (64) connected to the outputs of the preamplification circuit and the differentiator stage.

## Patentansprüche

1. Vorrichtung zur Verarbeitung und Digitalisierung eines Strahlungsenergiespektrums, Folgendes aufweisend:
• eine Ladungsvorverstärkungsschaltung (20) von der Bauart eines Integrators, die dazu ausgelegt ist, an einen Halbleiterdetektor angeschlossen zu werden;
• eine Energiemessschaltung (22) über eine Verzögerungsleitung, welche Schaltung am Ausgang der Vorverstärkungsschaltung angeschlossen ist; und
• einen Probenehmer (54), der am Ausgang der Energiemessschaltung angeschlossen ist,
**dadurch gekennzeichnet, dass** die Vorrichtung eine Synchronisationsschaltung (52) umfasst, die aufweist:
• eine Stromimpulsmessschaltung (56), die am Ausgang der Vorverstärkungsschaltung (20) angeschlossen ist und die Differenz zwischen dem Ausgang und einer Ableitung des Ausgangs der Vorverstärkungsschaltung bewirkt; und
• eine Unterscheidungsschaltung (66), die ein Binärsignal in Abhängigkeit vom Ausgang der Impulsmessschaltung (56) erzeugt, wobei dieses logische Signal die Probenahmemomente des Probenehmers (54) steuert.

2. Vorrichtung nach Anspruch 1, **dadurch gekennzeichnet, dass** die Synchronisationsschaltung (52) außerdem noch eine Filterschaltung (68) aufweist, die dazu ausgelegt ist, die Impulse des logischen Signals zu entfernen, die eine Dauer aufweisen, die länger ist als eine vorbestimmte Schwellendauer.

3. Vorrichtung nach Anspruch 2, **dadurch gekennzeichnet, dass** die vorbestimmte Schwellendauer kürzer oder gleich der Anlaufzeit der Ladungsvorverstärkungsschaltung (20) ist.

4. Vorrichtung nach einem der Ansprüche 1 bis 3, **dadurch gekennzeichnet, dass** die Integrationszeitkonstante der Vorverstärkungsschaltung (20) im Wesentlichen gleich der Ableitungszeitkonstanten der Impulsmessschaltung (56) ist.

5. Vorrichtung nach einem der vorhergehenden Ansprüche, **dadurch gekennzeichnet, dass** die Impulsmessschaltung (56) aufweist:
• eine Ableitungsstufe (58, 60, 62) mit einem Hochleistungsverstärker (58), einem am Eingang des Hochleistungsverstärkers (58) angeschlossenen Kondensator (62) und einem zwischen dem Eingang und dem Ausgang des Hochleistungsverstärkers angeschlossenen Widerstand (60); und
• eine Subtraktionsstufe (64), die an die Ausgänge der Vorverstärkungsschaltung und der Ableitungsstufe angeschlossen ist.
